# EUROPÄISCHE PATENTSCHRIFT

(11) **EP 1 094 915 B1**
(45) Veröffentlichungstag und Bekanntmachung des Hinweises auf die Patenterteilung: **10.09.2003**
(21) Anmeldenummer: 99939356.4
(22) Anmeldetag: 15.06.1999
(51) Int. Cl.: B23K 35/14, B22F 1/00

(54) **VERFAHREN ZUM VERKAPSELN VON LOTMETALLPULVER UND DANACH HERGESTELLTES LOTMETALLPULVER**
METHOD FOR ENCAPSULATING SOLDER METAL POWDERS AND SOLDER METAL POWDERS PRODUCED ACCORDING TO THIS METHOD
PROCEDE POUR L'ENCAPSULAGE DE POUDRE DE METAL DE BRASURE ET POUDRE DE METAL DE BRASURE AINSI OBTENUE

(30) Priorität: 15.06.1998 DE 19826756
(43) Veröffentlichungstag der Anmeldung: 02.05.2001
(73) Patentinhaber: Schulze, Jürgen, 14482 Potsdam (DE); Protsch, Walter, 14480 Potsdam (DE)
(72) Erfinder: Schulze, Jürgen, 14482 Potsdam (DE); Protsch, Walter, 14480 Potsdam (DE)
(74) Vertreter: Hannig, Wolf-Dieter, Dipl.-Ing.
(86) Internationale Anmeldenummer: DE9901777
(87) Internationale Veröffentlichungsnummer: WO99065640

(56) Entgegenhaltungen:
- WO-A-97/33713
- DE-A- 4 402 042
- US-A- 3 736 653
- US-A- 4 994 326

## Beschreibung

Die Erfindung betrifft ein Verfahren zum Verkapseln von Lotmetallpulvern, insbesondere Feinstlotmetallpulvern, bei dem die Pulver durch eine an der Oberfläche des Lotpulvers ablaufende Polymerisationsreaktion mit einer dünnen polymeren Schutzschicht versehen werden.

Die Erfindung betrifft ferner ein nach diesem Verfahren hergestelltes Lotmetallpulver mit einem Kern aus Lotmetall in einem Durchmesser von 1 bis 100 µm und einer den Kern umschließenden Schutzschicht aus Polymer.

Ein gattungsgemäßes Verfahren zur Herstellung von mikropartikulierten Reflow-Lötmitteln ist aus der DE 44 02 042 A1 bekannt, bei dem das kompakte Lotmetall in einer hochtemperierbaren organischen Flüssigkeit aufgeschmolzen, mit Hilfe des Strömungsdispergierverfahrens zu einem kugelsymmetrischen Kornband von vorzugsweise 3 bis 10 µm Durchmesser geführt und die organische Flüssigkeit soweit entfernt wird, daß die Metallpartikulate bedeckt bleiben, so daß sie in eine Emulsion zu überführen ist und die Einzelteilchen der Suspension und Emulsion nach der Methode der Komplexkoazervation mit einem Melaminpolymerisat des Schichtdickenbereichs von 50 bis 250 nm überzogen werden. Die mikropartikulierte organische Phase wird anschließend von der mikropartikulierten Metallphase quantitativ getrennt.

Diese mikropartikulierten Metallpulver sind zwar durch ein duroplastisches Polymersystem geschützt, können jedoch nur bei Einsatz sehr stark aktivierter Flußmittel wieder freigesetzt werden. Diese Flußmittel führen zur Zerstörung der mikroelektronischen Schaltkreise und sind daher ungeeignet.

Aus der EP 0 556 864 A1 ist außerdem ein Lotpulver bekannt, das mit einer Schutzschicht aus Parylenen versehen ist. Die Parylenschicht wird mittels einer Dampfabscheidung aufgebracht, wobei Dimere durch Pyrolyse in Monomere zerlegt, diese aus der Gasphase auf der Oberfläche der Pulverteilchen kondensieren, auf der dann die Polymerisationsreaktion und die Filmbildung erfolgt.

Dieses bekannte Verfahren hat den Nachteil, daß die für den Einsatz in Lotpasten notwendigen Schichtdicken <100 nm keine vollständige Kapselung bei allen Teilchen gewährleistet und nach wie vor eine meßbare Permeabilität gegenüber den für Lotpulver schädlichen kleinen Moleküle wie Wasser und Gase wie Sauerstoff und Schwefeldioxid besteht.
Auch ist dieses bekannte Kapselmaterial mit dem Nachteil behaftet, daß es nur mit hochaktiven Flußmitteln aufgelöst werden kann. Eine Anwendung für Lötprozesse ist daher auch nicht bekannt geworden.

Bei diesem Stand der Technik liegt der Erfindung die Aufgabe zugrunde, ein Verfahren und ein mikroverkapseltes Lot derart zu verbessern, daß das Metallpulver sicher vor äußeren oxidativen Einwirkungen geschützt und gleichzeitig die Kapselung das Metallpulver ohne Flußmitteleinwirkung nur durch Temperatureinfluß frei gibt.

Diese Aufgabe wird mit folgenden Verfahrensschritten
- a): Herstellen einer Suspension aus Pulver und einer hydrophoben Flüssigkeit,
- b): Erzeugen einer hydrophoben Oberflächenschicht auf jedem Metallpartikel durch Zusetzen eines kationischen Tensids mit einer Kettenlänge von C₁ bis C₂₀ unter ständigem Rühren zur Bildung einer Bürstenstruktur an der hydrophoben Schicht des Schrittes a),
- c): Rühren des Gemisches aus den Schritten a) und b) bis zur Bildung einer viskosen homogenen Masse,
- d): Zumischen eines radikalisch polymerisierbaren Monomers in die Masse des Schrittes c), das in der Lage ist, ein thermoplastisches Polymer mit einer Glastemperatur T_{g} von mindestens 60 °C unterhalb der Solidustemperatur des Lotpulvers zu bilden,
- e): Zugeben eines organischen Initiators zum Starten einer Grenzflächen-Polymerisationsreaktion unter Einbindung der hydrophoben Schicht des Schrittes a) und Bildung einer Schutzschicht aus thermoplastischem Polymer, das
- f): Flußmitteleigenschaften hat, Einbringen der Masse des Schrittes e) in eine wäßrige Vorlage unter ständigem Rühren, wobei die Vorlage zur Suspensionsstabilisierung einen Imulgator enthält, und Steuern der Polymerisationsreaktion durch Temperieren auf 50 bis 90 °C und Halten bei diesen Temperaturen für mindestens 120 min. und
- g): Abkühlen, Waschen und Abtrennen der in den Schritten e) und f) gekapselten Lotpulver
gelöst.

Nach einem weiteren bevorzugten Merkmal des erfindungsgemäßen Verfahrens werden als hydrophobe Flüssigkeiten nichttrocknende pflanzliche und/oder tierische Öle und/oder aromatische Lösungsmittel verwendet. Bevorzugt kommen als pflanzliche Öle Rizinusöl, Olivenöl oder Erdnußöl zum Einsatz.

In weiterer bevorzugter Ausgestaltung des erfindungsgemäßen Verfahrens werden als Tenside quaternäre Ammoniumsalze, vorzugsweise Dodecyltrimethylammoniumchlorid oder Cetyltrimethylammoniumchlorid, verwendet.

Ein weiteres bevorzugtes Merkmal des erfindunsggemäßen Verfahren sieht vor, daß als Monomer Methacrylsäure-2-hydroxyethylester oder Methylmethacrylat verwendet wird.

Zur Einleitung der Polymerisationsreaktion werden als Initiatoren organische Peroxide oder Azoverbindungen verwendet.

Die Aufgabe wird weiterhin mit einem mikroverkapselten Lotmetallpulver dadurch gelöst, daß der metallische Kern mit einer oberflächenaktiven hydrophoben Flüssigkeit und einem Tensid eine bürstenähnliche Struktur bildet, in der eine Flußmitteleigenschaften aufweisende thermoplastische polymere Kapselwand mechanisch verankert ist, wobei die Kapselwand eine Glastemperatur T_{g} von mindestens 60 °C unterhalb der Solidustemperatur des Kernes besitzt.

Die hydrophobe Schicht auf dem Metallkern besteht nach einem weiteren Merkmal aus einem nichtrocknenden pflanzlichen und/oder tierischen Öl und/oder aromatische Lösungsmittel, vorzugsweise Rizinusöl, Olivenöl oder Erdnußöl und einem kationischen Tensid mit einer Kettenlänge von C₁ bis C₂₀, deren Länge die Schichtdicke der Kapselwand mitbestimmt.
Geeignete Monomere für die Bildung der Kapselwand sind radikalisch polymerisierbare Monomere, vorzugsweise Methacrylsäure-2-hydroxyethylester oder Methylmethacrylat.

Durch die erfindungsgemäße Mikroverkapselung wird zum einen eine Konservierung der Pulvereigenschaften erreicht. Gleichzeitig gewährleistet die Hülle den Schutz vor einer Beeinflussung durch atmosphärische Einwirkungen wie Oxidation, Luftfeuchtigkeit und Deckschichtenbildung. Der oxidative Angriff auf die Metallpartikel innerhalb der Paste durch Aktivatoren wird ebenso verhindert. Dadurch erhöht sich auch die Stabilität gegenüber unerwünschten chemischen Reaktionen damit gefertigter Lotpasten. Die Gebrauchseigenschaften in Bezug auf die Verarbeitbarkeit und Lagerstabilität der Pasten verbessern sich deutlich.

Die erfindungsgemäße Kapselwand auf den anorganischen Partikeln führt des weiteren auch zu einer wesentlichen verbesserten Kopplung dieser Teilchen an die Polymermatrix bei Applikationen wie Pasten oder Farben, was zu geringerer Sedimentationsneigung und besseren rheologischen Eigenschaften führt.

Die eingesetzten Polymere besitzen eine Glastemperatur, d.h. die Temperatur, bei der das Polymer in den plastischen Zustand übergeht, von 60 bis 70 °C. Dies gewährleistet, daß die polymere Kapselhülle das Metallpulver vor dem Aufschmelzen freigibt und den Lötprozeß nicht behindert. Durch die Wahl des erfindungsgemäßen Monomers erhält das Kapselmaterial Flußmitteleigenschaften.

Weitere Vorteile und Einzelheiten ergeben sich aus der nachfolgenden Beschreibung unter Bezugnahme auf die beigefügten Zeichnungen.

Die Erfindung soll nachstehend an mehreren Ausführungsbeispielen näher erläutert werden.

Die dazugehörige Zeichnung zeigt den prinzipiellen Aufbau eines nach dem erfindungsgemäßen Verfahren umhüllten Metallpartikels.

Der metallische Kern trägt die Bezugsziffer 1. Um den Kern **1** ist eine Schicht **2** eines nicht trocknenden pflanzliches Öles, beispielsweise Rizinusöl, als hydrophobe Grenzfläche gelegt. Vom Kern **1** ragt das längerkettige Tensid **3,** beispielsweise Dodecyltrimethylammoniumchlorid, in bürstenähnlicher Struktur auf.

In dieser Struktur ist die thermoplastische polymere Kapselwand **4** verklammert.

### Beispiel 1

Zur erfindungsgemäßen Mikroverkapselung des Lotpulvers werden etwa 100 bis 200 g Lot mit ca. 15% Öl eingewogen. Der Einwaage wird eine bestimmte Menge einer Tensidlösung zugesetzt. Die Menge des Tensids ist dabei abhängig vom Typ und beträgt bei Dodecyltrimethylammoniumchlorid mindestens 0,053mg pro Gramm Lot. Bedingt durch den ca.-Anteil Öl in der Einwaage wird mit einem Überschuß an Tensid gearbeitet, der nachweislich innerhalb gewisser Grenzen unproblematisch für den weiteren Prozeß ist (110% der theoretischen Menge, bezogen auf die Gesamteinwaage, zeigen keine Auswirkungen).
Danach wird das System Lot-Tensid-Öl intensiv durch Rühren gemischt. Wenn dieses Gemisch homogen ist und eine homogene Masse bildet, werden pro Gramm Lot 1 bis 4 mg Methacrylsäure-2-hydroxyethylester und pro Gramm Monomer 0,1 bis 0,3 mg Benzoylperoxid zugegeben und intensiv gemischt.

In einem Becherglas werden 600-800 ml Wasser mit einem Zusatz von 0,1 bis 1,0 % Polyvinylpyrolidon K 90 vorgelegt. Diese Vorlage wird mit einem Dispergiergerät, z.B. Ultra-Turrax der Firma IKA, mit einer Drehzahl von 7200 U/min gerührt. Zu dieser Vorlage gibt man die Lot-Öl-Tensid-Mischung und erhöht die Drehzahl auf 9000 U/min. Danach wird das System auf 55 °C temperiert. Diese Temperatur wird für 90 Minuten gehalten und dann auf 65 °C erhöht. Die zweite Reaktionsphase dauert 120 min.
Anschließend läßt man auf Raumtemperatur abkühlen und dekantiert den wäßrigen Überstand. Das Reaktionsgefäß wird mit einer kleinen Menge Ethanol gespült, um einen Übergang zur Endreinigung mit Dichlormethan zu ermöglichen.

Nach Abgießen des Alkohols wird das am Boden des Becherglases befindliche Lotpulver in Dichlormethan aufgerührt und in ein anderes Becherglas überführt. Der "Waschvorgang" wird mehrmals bis zur Klare des Überstandes wiederholt. Es schließt sich das Trocknen des noch feuchten Lotpulvers bei Raumtemperatur an.

### Beispiel 2

250 g Lotpulver werden mit 14 mg Cetyltrimethylammoniumchlorid, 09 g Methylmethacrylat und 260 mg Benzoylperoxid in 40 g Erdnußöl vermischt.
Dieses Reaktionsgemisch gibt man in 600 ml Wasser und suspendiert bei 9000 U/min. Sobald eine homogene Suspension erreicht ist, temperiert man auf 60 °C. Nach 90 min erhöht man die Temperatur um 10 Grad und hält diese Temperatur 120 min konstant. Danach wird abgekühlt und entsprechend Beispiel 1 weiter behandelt.

### Aufstellung der verwendeten Bezugszeichen

| | |
|---|---|
| Metallkern | 1 |
| Ölschicht | 2 |
| Tensid | 3 |
| polymere Kapselwand | 4 |

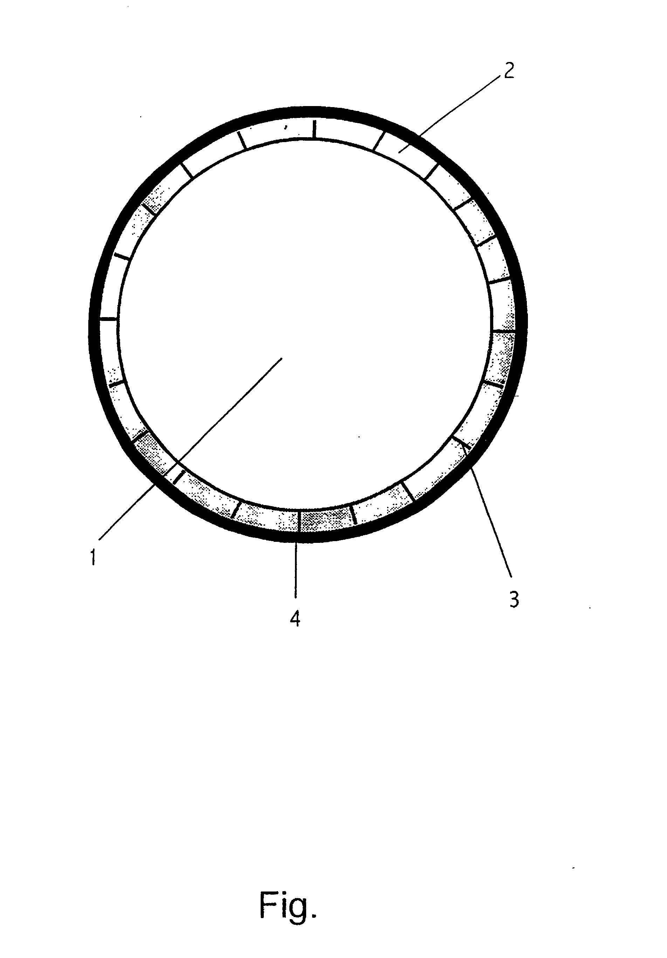

## Patentansprüche

1. Verfahren zum Verkapseln von Lotmetallpulvern, insbesondere Feinstlotmetallpulvern, bei dem die Pulver durch eine an der Oberfläche des Lotpulvers ablaufende Polymerisationsreaktion mit einer dünnen polymeren Schutzschicht versehen werden, mit folgenden Schritten
a) Herstellen einer Suspension aus Pulver und einer hydrophoben Flüssigkeit,
b) Erzeugen einer hydrophoben Oberflächenschicht auf jedem Metallpartikel durch Zusetzen eines kationischen Tensids mit einer Kettenlänge von C₁ bis C₂₀ unter ständigem Rühren zur Bildung einer Bürstenstruktur an der hydrophoben Schicht des Schrittes a),
c) Rühren des Gemisches aus den Schritten a)und b) bis zur Bildung einer viskosen homogenen Masse,
d) Zumischen eines radikalisch polymerisierbaren Monomers in die Masse des Schrittes c), das in der Lage ist, ein thermoplastisches Polymer mit einer Glastemperatur T_{g} von mindestens 60 °C unterhalb der Solidustemperatur des Lotpulvers zu bilden,
e) Zugeben eines organischen Initiators zum Starten einer Grenzflächen-Polymerisationsreaktion unter Einbindung der hydrophoben Schicht des Schrittes b) und Bildung einer Schutzschicht aus thermoplastischem Polymer, die Flußmitteleigenschaften hat,
f) Einbringen der Masse des Schrittes e) in eine wäßrige Vorlage unter ständigem Rühren, wobei die Vorlage zur Suspensionsstabilisierung einen Emulgator enthält, und Steuern der Polymerisationsaktion durch Temperieren auf 50 bis 90 °C und Halten bei diesen Temperaturen für mindestens 120 min. und
g) Abkühlen, Waschen und Abtrennen der in den Schritten e) und f) gekapselten Lotpulver.

2. Verfahren nach Anspruch 1,
**dadurch gekennzeichnet, daß** als hydrophobe Flüssigkeit nichttrocknende pflanzliche und/oder tierische Öle und/oder aromatische Lösungsmittel, vorzugsweise Rizinusöl, Olivenöl oder Erdnußöl verwendet wird.

3. Verfahren nach Anspruch 1,
**dadurch gekennzeichnet, daß** als Tenside quaternäre Ammoniumsalze, vorzugsweise Dodecyltrimethylammoniumchlorid oder Cetyltrimethylammoniumchlorit, verwendet werden.

4. Verfahren nach Anspruch 1,
**dadurch gekennzeichnet, daß** als Monomer Methacrylsäure-2-hydroxyethylester oder Methylmethacrylat verwendet wird.

5. Verfahren nach Anspruch 1,
**dadurch gekennzeichnet, daß** als Initiatoren organische Peroxide oder Azoverbindungen verwendet werden.

6. Mikroverkapseltes Lotmetallpulver zur Durchführung des Verfahrens nach Anspruch 1, mit einem Kern **(1)** aus Lotmetall in einem Durchmesser von 1 bis 100 µm und einer den Metallkern umschließenden Polymerschicht **(4)**, **dadurch gekennzeichnet, daß** der Kern **(1)** mit einer oberflächenaktiven hydrophoben Flüssigkeit und einem Tensid **(2)** eine bürstenähnliche Struktur **(3)** bildet, in der eine Flußmitteleigenschaften aufweisende thermoplastische polymere Kapselwand **(4)** mechanisch verankert ist, und wobei die polymere Kapselwand eine Glastemperatur T_{g} von mindestens 60 °C unterhalb der Solidustemperatur des Kernes besitzt.

7. Mikroverkapseltes Lotmetallpulver nach Anspruch 6,
**dadurch gekennzeichnet, daß** die hydrophobe Flüssigkeit ein nichtrocknendes pflanzliches und/oder tierisches Öl und/oder aromatisches Lösungsmittel, vorzugsweise Rizinusöl, Olivenöl oder Erdnußöl, ist.

8. Mikroverkapseltes Lotmetallpulver nach Anspruch 6,
**dadurch gekennzeichnet, daß** das Tensid ein kationisches Tensid mit einer Kettenlänge von C₁ bis C₂₀ ist, deren Länge die Schichtdicke der Polymerschicht mitbestimmt.

9. Mikroverkapseltes Lotmetallpulver nach Anspruch 6,
**dadurch gekennzeichnet, daß** das Polymer aus einem radikalisch polymerisierbaren Monomer gebildet ist.

## Claims

1. Method for encapsulating solder metal powders, especially finest solder metal powder, the powder is provided with a thin polymer protective layer by a polymerization reaction running on the surface of the solder powder, with following steps:
a) producing a suspension of powder and a hydrophobic liquid,
b) generating a hydrophobic surface layer on each metal particle by adding a cationic tenside with a chain length of C₁ through C₂₀ with continuous stirring to form a brush structure on the hydrophobic layer of step a),
c) stirring the mixture of steps a) and b) until formation of a viscous homogeneous mass,
d) adding a radically polymerizable monomer to the mass of step c) and which is capable of forming a thermoplastic polymer with a glass temperature T_{g} of at least 60 °C below the solidus temperature of the solder powder,
e) adding an organic initiator to start an interfacial polymerization reaction with incorporation of the hydrophobic layer of step b) and formation of a protective layer of thermoplastic polymer which has fluxing agent characteristics,
f) introducing the mass of step e) into an aqueous preparation with continuous stirring, whereby the preparation contains an emulsifier for suspension stabilization and controlling the polymerization reaction by tempering to 50 ° to 90 °C and maintaining this temperature for at least 120 min, and
g) cooling, washing and recovering the encapsulated solder powder of steps e) and f).

2. Method according to claim 1, **characterized in that** as the hydrophobic liquid a non drying and/or animal oil and/or aromatic solvent, preferably castor oil, olive oil or peanut oil is used.

3. Method according to claim 1, **characterized in that** as the tenside a quaternary ammonium salt, preferably dodecyltrimethylammoniumchloride or cetyltrimethylammoniumchloride, is used.

4. Method according to claim 1, **characterized in that** as the monomer methacrylicacid-2-hydroxyethylester or methylmethacrylate is used.

5. Method according to claim 1, **characterized in that** as the initiator, an organic peroxide or azo compound is used.

6. Microencapsulated solder powder for carrying out the method according to claim 1, with a core of solder metal of a diameter of 100 µm and a polymer layer surrounding the metal core, whereby the core (1) is formed with a brush like structure (3) by a surface active hydrophobic liquid and a tenside (2) in which a thermoplastic polymer capsule wall (4) is mechanically anchored and has fluxing agent characteristics, and whereby the polymer capsule wall has a glass temperature T_{g} of at least 60 °C below the solidus temperature of the core.

7. Microencapsulated solder powder according to claim 6, **characterized in that** the hydrophobic liquid is a non drying vegetable and/or animal oil and/or aromatic solvent, preferably castor oil, olive oil or peanut oil.

8. Microencapsulated solder metal powder according to claim 6, **characterized in that** the tenside is a cationic tenside with a chain length of C₁ to C₂₀ whose length determined the layer thickness of the polymer layer.

9. Microencapsulated solder metal powder according to claim 6, **characterized**, that the polymer is formed from a radically polymerizable monomer.

## Revendications

1. Procédé pour l'encapsulage de poudres de métal de brasure, en particulier de poudres très fines de métal de brasure, dans lequel les poudres sont pourvues d'une mince couche protectrice polymère par une réaction de polymérisation se déroulant à la surface de la poudre de brasure, avec les étapes suivantes
a) produire une suspension à partir de poudre et d'un liquide hydrophobe,
b) générer une couche superficielle hydrophobe sur chaque particule de métal en ajoutant un agent de surface cationique avec une longueur de chaîne de C₁ à C₂₀ en remuant continuellement pour former une structure de brosse sur la couche hydrophobe de l'étape a),
c) remuer le mélange des étapes a) et b) jusqu'à la formation d'une masse homogène visqueuse,
d) ajouter un monomère polymérisable de façon radicalaire à la masse de l'étape c), lequel est à même de former un polymère thermoplastique avec une température de transition vitreuse T_{g} d'au moins 60 °C au-dessous de la température solidus de la poudre de brasure,
e) ajouter un excitant organique pour démarrer une réaction de polymérisation d'interface en intégrant la couche hydrophobe de l'étape b) et former une couche protectrice de polymère thermoplastique, qui présente des propriétés de fondant,
f) introduire la masse de l'étape e) dans une préparation aqueuse en remuant continuellement, la préparation contenant un émulsifiant pour la stabilisation de la suspension, et commander l'action de polymérisation en tempérant à une température de 50 à 90 °C et maintenir à ces températures pour 120 minutes au moins, et
g) refroidir, laver et séparer les poudres de brasure encapsulées dans les étapes e) et f).

2. Procédé selon la revendication 1, **caractérisé par le fait que** l'on utilise en tant que liquide hydrophobe des huiles végétales et/ou animales non siccatives et/ou des solvants aromatiques, de préférence l'huile de ricin, l'huile d'olive ou l'huile d'arachide.

3. Procédé selon la revendication 1, **caractérisé par le fait que** l'on utilise en tant qu'agents de surface des sels d'ammonium quaternaires, de préférence le chlorure de dodécyltriméthylammonium ou le chlorite de cétyltriméthylammonium.

4. Procédé selon la revendication 1, **caractérisé par le fait que** l'on utilise en tant que monomère l'acide méthacrylique-2-hydroxyéthylester ou le méthacrylate de méthyle.

5. Procédé selon la revendication 1, **caractérisé par le fait que** l'on utilise comme excitants des peroxydes organiques ou des composés azoïques.

6. Poudre de métal de brasure micro-encapsulée pour la mise en oeuvre du procédé selon la revendication 1, avec un noyau (1) en métal de brasure en un diamètre de 1 à 100 µm et avec une couche polymère (4) entourant le noyau de métal, **caractérisée par le fait que** le noyau (1) forme avec un liquide hydrophobe tensio-actif et avec un agent de surface (2) une structure (3) ressemblant à une brosse dans laquelle est ancrée mécaniquement une paroi capsule (4) polymère thermoplastique qui présente des propriétés de fondant, et la paroi capsule polymère possédant une température de transition vitreuse T_{g} d'au moins 60 °C au-dessous de la température solidus du noyau.

7. Poudre de métal de brasure micro-encapsulée selon la revendication 6, **caractérisée par le fait que** le liquide hydrophobe est une huile végétale et/ou animale non siccative et/ou un solvant aromatique, de préférence de l'huile de ricin, de l'huile d'olive ou de l'huile d'arachide.

8. Poudre de métal de brasure micro-encapsulée selon la revendication 6, **caractérisée par le fait que** l'agent de surface est un agent de surface cationique avec une longueur de chaîne de C₁ à C₂₀ dont la longueur détermine elle aussi l'épaisseur de couche de la couche polymère.

9. Poudre de métal de brasure micro-encapsulée selon la revendication 6, **caractérisée par le fait que** le polymère est formé à partir d'un monomère polymérisable de façon radicalaire.
